# EUROPEAN PATENT SPECIFICATION

(11) **EP 3 819 705 B1**
(45) Date of publication and mention of the grant of the patent: **30.10.2024**
(21) Application number: 20195880.8
(22) Date of filing: 14.09.2020
(51) Int. Cl.: G02F 1/1345

(54) **DISPLAY DEVICE**
ANZEIGEVORRICHTUNG
DISPOSITIF D'AFFICHAGE

(30) Priority: 05.11.2019 KR 20190140287
(43) Date of publication of application: 12.05.2021
(73) Proprietor: Samsung Display Co., Ltd., Yongin-si Gyeonggi-do 17113 (KR)
(72) Inventor: Choi, Ho Sup, 7-106 Seoul (KR); Kim, Sung Soo, 6121-1003 Gyeonggi-do (KR); Lee, Hyun Ho, 75-7 Seoul (KR)
(74) Representative: Dr. Weitzel & Partner

(56) References cited:
- US-A1- 2018 067 353
- US-A1- 2019 278 123

## Description

### BACKGROUND

### FIELD

The present disclosure generally relates to a display device, more specifically to a display device with least non-display area.

### Discussion of the Background

A display device such as a liquid crystal display (LCD), a light emitting diode (LED) display, etc. includes a display panel including a plurality of pixels that can display an image. Each pixel may include a pixel electrode for receiving a data signal, and the pixel electrode may be connected to at least one transistor to receive the data signal.

Meanwhile, by reducing a bezel area of the display device, it is possible to increase a screen-to-body ratio of the display device, that is, a ratio of the screen to the display device, when viewed from a front thereof. The screen-to-body ratio represents a technical advancement of the display device, and at the same time, it is important to a consumer when selecting a product.

US 2018/067353 A1 discloses a display device with an increased screen-to-body ratio. The features known from this document have been summarized in the preamble of claim 1.

US 2019/278123 A1 discloses a display device and a method of manufacturing the same, wherein circuit dummy pads and/or circuit signal pads disposed on a circuit film are electrically connected to substrate dummy pads respectively to substrate signal pads via an anisotropic conductive film.

The above information disclosed in this Background section is only for understanding of the background of the inventive concepts, and, therefore, it may contain information that does not constitute prior art.

### SUMMARY

Additional features of the inventive concepts will be set forth in the description which follows, and in part will be apparent from the description, or may be learned by practice of the inventive concepts.

Embodiments provide a display device that may have an enlarged area occupied by a display area by disposing a flexible film that transmits a driving signal required for operation of the display device on a side surface of the display panel. In addition, the embodiments provide a flexible film that is stably bonded to improve reliability of the display device.

An embodiment of the present invention provides a display device including: a display panel including a display area and at least a flexible film attached to a first side surface of the display panel, wherein a normal vector of the first side surface is orientated in a second direction, and wherein the display panel may include a signal line extending from the display area, and includes a substrate and at least a signal pad disposed on the substrate, wherein a portion of the at least one signal pad faces towards the same direction as the first side surface and that may be connected to the signal line. The display panel of the embodiment includes at least a dummy pad disposed adjacent to the signal pad in a first direction on the substrate, wherein the first direction is orthogonal to the second direction, that is the at least one first signal pad and the at least one dummy pad are positioned one behind another along the first side surface of the display panel. The flexible film includes a base film disposed to face the first side surface, and a driving electrode disposed between the base film and the signal pad, and, as seen in the second direction, overlapping the portion of the at least one signal pad and being electrically connected to the at least one signal pad. The display panel further comprises an encapsulation substrate spaced apart from the substrate in a third direction, wherein the third direction is orthogonal to the first direction and second direction, wherein the at least one signal pad and the at least one dummy pad are disposed between the substrate and the encapsulation substrate on a surface of the substrate whose normal vector is oriented in the third direction. The dummy pad does not overlap an electrode.

The display panel may be partially or fully flat on a front surface thereof. The flat surface may be connected directly to the first side surface, that is, the flat surface may be bounded by the first side surface. According to an embodiment comprises the display panel four side surfaces along its circumference, and the flat surface may be directly connected to all side surfaces without any rounded portion therebetween. The display panel may include a peripheral area disposed outside of the display area. The peripheral area may be part of the flat surface. According to an alternative embodiment, the peripheral surface is part of the side surface of the display panel and the display area reaches up to the connecting edge with the side surface.

Side surfaces of the signal pad and the dummy pad may be arranged along the first side of the display panel.

The display area may include a gate line and a data line that are insulated from each other and cross each other, and the signal pad and the dummy pad may respectively include the same material as that of the gate line and the data line.

The flexible film may further include an anisotropic conductive layer (or film) disposed between the base film and the driving electrode.

The anisotropic conductive layer may include an adhesive layer and conductive particles.

The display device may include a plurality of flexible films, and one of the plurality of flexible films may include a plurality of driving electrodes.

The dummy pad may be disposed between a plurality of signal pads, and one flexible film may overlap at least one dummy pad.

The dummy pad overlapping the one flexible film may overlap the outermost side of the one flexible film. The outermost side may be a boundary area of the flexible film disposed along the first side surface.

The display device may include the plurality of flexible films, at least one of the plurality of flexible films may overlap the dummy pad, and at least one of the plurality of flexible films may not overlap the dummy pad.

The flexible film may include a plurality of drive electrodes, and the plurality of driving electrodes may include a first driving electrode and a second driving electrode that have different widths.

A width of the first driving electrode may be greater than that of the second driving electrode, and the first driving electrode may be disposed at the outermost side of the plurality of driving electrodes.

A width of the first driving electrode may be greater than that of the second driving electrode, and at least one of the plurality of flexible films may overlap at least two of the first driving electrodes.

A method for manufacturing a display device comprises the following steps: preparing of the dummy pad and a plurality of signal pads disposed on the substrate on the surface of the substrate whose normal vector is oriented in the third direction, wherein the dummy pad and the plurality of signal pads are arranged along the first direction; coating a metal material on the first side surface of the display panel electrically connecting at least the plurality of signal pads to the metal material; eliminating the metal material along the first direction by using a laser process so as to expose the dummy pad; and pattern of the remaining metal material by using the dummy pad as a reference point to manufacture a plurality of driving electrodes.

According to the embodiments, it is possible to enlarge an area occupied by a display area by disposing a flexible film that transmits a driving signal required for operation of the display device on a side surface of the display panel. In addition, according to the embodiments, it is possible to improve reliability of a display device by providing a stably bonded flexible film.

It is to be understood that both the foregoing general description and the following detailed description are exemplary and explanatory and are intended to provide further explanation of the invention as claimed.

### BRIEF DESCRIPTION OF THE DRAWINGS

The accompanying drawings, which are included to provide a further understanding of the invention and are incorporated in and constitute a part of this specification, illustrate exemplary embodiments of the invention, and together with the description serve to explain the inventive concepts.
FIG. 1 illustrates a schematic perspective view of a display panel according to an embodiment.
FIG. 2 illustrates a schematic top plan view of a display panel according to an embodiment.
FIG. 3 illustrates a circuit diagram of one pixel according to an embodiment.
FIG. 4 illustrates a partial cross-sectional view of a display device according to an embodiment.
FIG. 5 illustrates a partial cross-sectional view of a display device according to an embodiment.
FIG. 6 illustrates a cross-sectional view of a first side of a display panel according to an embodiment.
FIG. 7, FIG. 8, and FIG. 9 respectively illustrate a cross-sectional view of a first side during a manufacturing process according to an embodiment.
FIG. 10, FIG. 11, FIG. 12, and FIG. 13 respectively illustrate a cross-sectional view of a first side of a display panel according to an embodiment.

### DETAILED DESCRIPTION

In the following description, for the purposes of explanation, numerous specific details are set forth in order to provide a thorough understanding of various exemplary embodiments or implementations of the invention. As used herein "embodiments" and "implementations" are interchangeable words that are non-limiting examples of devices or methods employing one or more of the inventive concepts disclosed herein. It is apparent, however, that various exemplary embodiments may be practiced without these specific details or with one or more equivalent arrangements. In other instances, well-known structures and devices are shown in block diagram form in order to avoid unnecessarily obscuring various exemplary embodiments. Further, various exemplary embodiments may be different, but do not have to be exclusive. For example, specific shapes, configurations, and characteristics of an exemplary embodiment may be used or implemented in another exemplary embodiment without departing from the inventive concepts.

Unless otherwise specified, the illustrated exemplary embodiments are to be understood as providing exemplary features of varying detail of some ways in which the inventive concepts may be implemented in practice. Therefore, unless otherwise specified, the features, components, modules, layers, films, panels, regions, and/or aspects, etc. (hereinafter individually or collectively referred to as "elements"), of the various embodiments may be otherwise combined, separated, interchanged, and/or rearranged without departing from the inventive concepts.

The use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, property, etc., of the elements, unless specified. Further, in the accompanying drawings, the size and relative sizes of elements may be exaggerated for clarity and/or descriptive purposes. When an exemplary embodiment may be implemented differently, a specific process order may be performed differently from the described order. For example, two consecutively described processes may be performed substantially at the same time or performed in an order opposite to the described order. Also, like reference numerals denote like elements.

When an element, such as a layer, is referred to as being "on," "connected to," or "coupled to" another element or layer, it may be directly on, connected to, or coupled to the other element or layer or intervening elements or layers may be present. When, however, an element or layer is referred to as being "directly on," "directly connected to," or "directly coupled to" another element or layer, there are no intervening elements or layers present. To this end, the term "connected" may refer to physical, electrical, and/or fluid connection, with or without intervening elements. Further, the D1-axis, the D2-axis, and the D3-axis are not limited to three axes of a rectangular coordinate system, such as the x, y, and z - axes, and may be interpreted in a broader sense. For example, the D1-axis, the D2-axis, and the D3-axis may be perpendicular to one another, or may represent different directions that are not perpendicular to one another. For the purposes of this disclosure, "at least one of X, Y, and Z" and "at least one selected from the group consisting of X, Y, and Z" may be construed as X only, Y only, Z only, or any combination of two or more of X, Y, and Z, such as, for instance, XYZ, XYY, YZ, and ZZ. As used herein, the term "and/or" includes any and all combinations of one or more of the associated listed items.

Although the terms "first," "second," etc. may be used herein to describe various types of elements, these elements should not be limited by these terms. These terms are used to distinguish one element from another element. Thus, a first element discussed below could be termed a second element without departing from the teachings of the disclosure.

Spatially relative terms, such as "beneath," "below," "under," "lower," "above," "upper," "over," "higher," "side" (e.g., as in "sidewall"), and the like, may be used herein for descriptive purposes, and, thereby, to describe one elements relationship to another element(s) as illustrated in the drawings. Spatially relative terms are intended to encompass different orientations of an apparatus in use, operation, and/or manufacture in addition to the orientation depicted in the drawings. For example, if the apparatus in the drawings is turned over, elements described as "below" or "beneath" other elements or features would then be oriented "above" the other elements or features. Thus, the exemplary term "below" can encompass both an orientation of above and below. Furthermore, the apparatus may be otherwise oriented (e.g., rotated 90 degrees or at other orientations), and, as such, the spatially relative descriptors used herein interpreted accordingly.

The terminology used herein is for the purpose of describing particular embodiments and is not intended to be limiting. As used herein, the singular forms, "a," "an," and "the" are intended to include the plural forms as well, unless the context clearly indicates otherwise. Moreover, the terms "comprises," "comprising," "includes," and/or "including," when used in this specification, specify the presence of stated features, integers, steps, operations, elements, components, and/or groups thereof, but do not preclude the presence or addition of one or more other features, integers, steps, operations, elements, components, and/or groups thereof. It is also noted that, as used herein, the terms "substantially," "about," and other similar terms, are used as terms of approximation and not as terms of degree, and, as such, are utilized to account for inherent deviations in measured, calculated, and/or provided values that would be recognized by one of ordinary skill in the art.

Unless otherwise defined, all terms (including technical and scientific terms) used herein have the same meaning as commonly understood by one of ordinary skill in the art to which this disclosure is a part. Terms, such as those defined in commonly used dictionaries, should be interpreted as having a meaning that is consistent with their meaning in the context of the relevant art and should not be interpreted in an idealized or overly formal sense, unless expressly so defined herein.

The present invention will be described more fully hereinafter with reference to the accompanying drawings, in which embodiments of the invention are shown. As those skilled in the art would realize, the described embodiments may be modified in various different ways, all without departing from the scope of the present claims.

To clearly describe the present disclosure, portions which do not relate to the description are omitted, and like reference numerals designate like elements throughout the specification.

Further, in the drawings, the size and thickness of each element are arbitrarily illustrated for ease of description, and the present disclosure is not necessarily limited to those illustrated in the drawings. In the drawings, the thicknesses of layers, films, panels, regions, etc., are exaggerated for clarity. In the drawings, for ease of description, the thicknesses of some layers and areas are exaggerated.

It will be understood that when an element such as a layer, film, region, or substrate is referred to as being "on" another element, it can be directly on the other element or intervening elements may also be present. In contrast, when an element is referred to as being "directly on" another element, there are no intervening elements present. Further, in the specification, the word "on" or "above" means disposed on or below the object portion, and does not necessarily mean disposed on the upper side of the object portion based on a gravitational direction.

In addition, unless explicitly described to the contrary, the word "comprise" and variations such as "comprises" or "comprising" will be understood to imply the inclusion of stated elements but not the exclusion of any other elements.

Further, throughout the specification, the phrase "in a plan view" means viewing a target portion from the top, and the phrase "in a cross-sectional view" means viewing a cross-section formed by vertically cutting a target portion from the side.

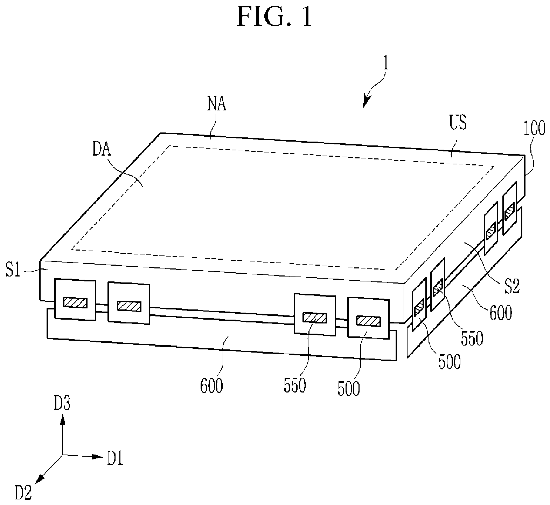

Hereinafter, a display device according to an embodiment will be described with reference to FIG. 1. FIG. 1 illustrates a schematic perspective view of a display panel according to an embodiment.

First, referring to FIG. 1, a display device 1 according to an embodiment includes a display panel 100 displaying an image through a first planar surface US, and a plurality of flexible films 500 attached to side surfaces S1 and S2 of the display panel 100. In the present specification, the flexible films 500 attached to the first side surface S1 and the second side surface S2 of the display panel 100 are illustrated, but are not limited thereto.

The display panel 100 may be, for example, an organic light emitting display panel, a liquid crystal display panel, a plasma display panel, an electrophoretic display panel, a microelectromechanical system (MEMS) display panel, or an electrowetting display panel. In the present specification, an embodiment in which the display panel 100 is an organic light emitting display panel is described, but the present invention is not limited thereto.

The display panel 100 includes a display area DA displaying an image through the first planar surface US, and a peripheral area NA disposed outside the display area DA when viewed in a plan view. The peripheral area NA may be formed at an edge portion of the display panel 100, and it may surround the display area DA, but is not limited thereto.

The flexible film 500 may be connected to a printed circuit board 600. The printed circuit board 600 may supply an image data signal and/or a data control signal to a driving chip 550 included in the flexible film 500. Also, the printed circuit board 600 may supply a gate control signal to the driving chip 550 included in the flexible film 500.

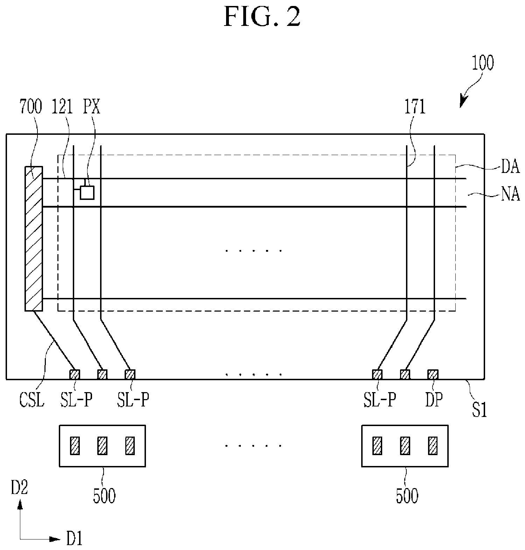

Hereinafter, the display panel 100 according to the embodiment will be described in more detail with reference to FIG. 2. FIG. 2 illustrates a schematic top plan view of a display panel according to an embodiment. In this case, one flexible film corresponding to a plurality of pads is illustrated in a planar form for convenience.

As described above, the display panel 100 includes the display area DA and the peripheral area NA. The display area DA is provided with a plurality of pixels PX. The plurality of pixels PX may be arranged in a matrix form in the display area DA. In FIG. 2, only one pixel is shown for better comprehension and ease of description.

The display panel 100 includes a plurality of signal lines 121 and 171, a plurality of pixels PX connected to the plurality of signal lines 121 and 171, and a plurality of signal pads SL-P electrically connected to the plurality of signal lines 121 and 171.

The plurality of signal lines 121 and 171 include a gate line 121 extending along a first direction D1 and a data line 171 that is insulated from and crosses the gate line 121. Each of the gate line 121 and the data line 171 may be connected to the pixel PX.

A gate driving circuit 700 to which the plurality of gate lines 121 are connected may be disposed in the peripheral area NA. A control signal line CSL may be connected to the gate driving circuit 700 to provide a control signal to the gate driving circuit 700.

The display panel 100 may include the signal lines CSL and 171, particularly, the control signal line CSL and the plurality of signal pads SL-P electrically connected to the data line 171. In the embodiments, the plurality of signal pads SL-P may be arranged on the first side surface S1 of the display panel 100. In the present specification, for the sake of convenience, only an embodiment in which the plurality of signal pads SL-P are disposed on the first side surface S1 is illustrated, but the present invention is not limited thereto, and as shown in FIG. 1, the plurality of signal pads SL-P may be disposed on the side surface S2. Constituent elements on the first side surface S1 described below may be applied in the same form on the second side surface S2.

In addition, the display device according to the embodiment includes a dummy pad DP arranged in parallel to the signal pad SL-P. The signal pad SL-P and the dummy pad DP are arranged side by side along the first direction D1. The signal pad SL-P and the dummy pad DP are disposed on the first side surface S1 along the first direction D1.

In the present specification, a pad is a term including the signal pad SL-P and the dummy pad DP, and a signal line is a term including the gate line 121, the data line 171, and the control signal line CSL.

In the present specification, the structure in which three pads SL-P and DP correspond to one flexible film 500 is illustrated and described, but the present invention is not limited thereto, and one flexible film 500 may overlap at least two or more pads.

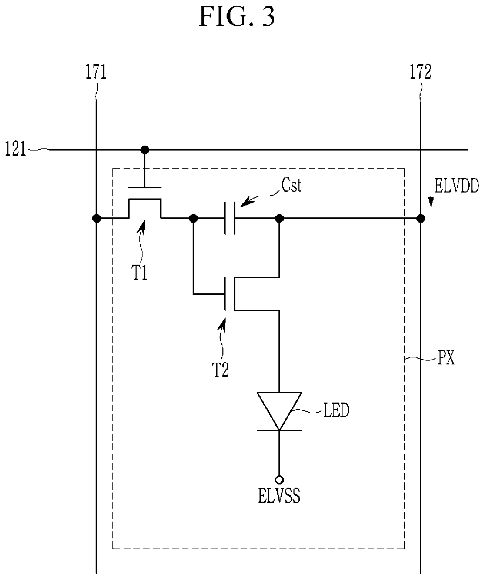

Hereinafter, one pixel PX included in the display area DA according to an embodiment will be schematically described with reference to FIG. 3. FIG. 3 illustrates a circuit diagram of one pixel according to an embodiment.

Referring to FIG. 3, the pixel PX may refer to a region partitioned by a plurality of signal lines 121, 171, and 172, and refers to a minimum unit for displaying an image. The display device displays an image using a plurality of pixels.

The signal lines include a plurality of gate lines 121 for transmitting a gate signal (or a scan signal), a plurality of data lines 171 for transmitting a data signal, and a plurality of driving voltage lines 172 for transmitting a driving voltage ELVDD. Both the gate line 121 and the data line 171 will be referred to as a data conductor, and the driving voltage line 172 will be referred to as a gate conductor.

The gate lines 121 extend in a substantially row direction and are substantially parallel to each other, and vertical portions of the data lines 171 and the driving voltage lines 172 extend in a substantially column direction and are substantially parallel to each other.

Each pixel PX includes a switching thin film transistor T1, a driving thin film transistor T2, a storage capacitor Cst, and a light emitting diode (LED). Although not shown in the drawings, one pixel PX may further include an additional transistor and an additional capacitor to compensate a current provided to the light emitting diode.

The switching transistor T1 transmits a data signal applied to the data line 171 to the driving transistor T2 in response to a scan signal applied to the gate line 121. The driving transistor T2 transmits an output current Id whose magnitude varies according to a voltage applied between a control terminal and an output terminal thereof. The storage capacitor Cst charges the data signal applied to the control terminal of the driving transistor T2 and maintains the data signal even after the switching transistor T1 is turned off.

The light emitting diode LED is provided with an anode connected to the output terminal of the driving transistor T2 and a cathode connected to a common voltage ELVSS. The light emitting diode LED displays an image by emitting light with variable intensity according to the output current of the driving transistor T2.

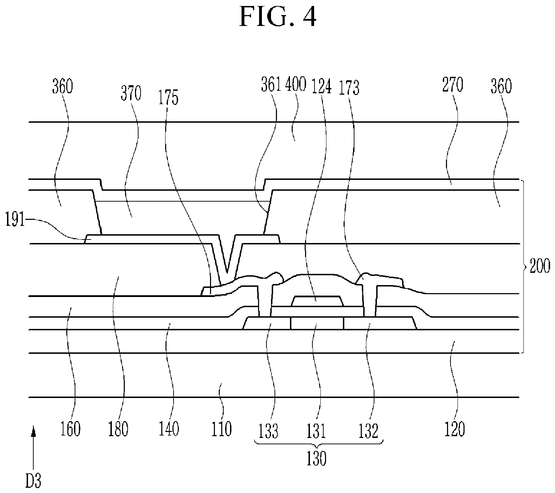

Hereinafter, a stacked structure of one pixel according to the embodiment described with reference to FIG. 3 will be described with reference to FIG. 4. FIG. 4 illustrates a partial cross-sectional view of a display device according to an embodiment.

According to the embodiment, a circuit portion 200 disposed on a substrate 110 includes a buffer layer 120. The buffer layer 120 may include an inorganic insulating material such as a silicon oxide, a silicon nitride, or an aluminum oxide, or may include an organic insulating material such as a polyimide acryl. In some embodiments, the buffer layer 120 may be omitted. The buffer layer 120 may flatten one surface of the substrate 110 or may prevent moisture, impurities, and the like from flowing into a light emitting layer 370.

A semiconductor layer 130 is disposed on the buffer layer 120. The semiconductor layer 130 may include an amorphous semiconductor, a polycrystalline semiconductor, or an oxide semiconductor.

The semiconductor layer 130 may include a source region 132 connected to a source electrode 173, a drain region 133 connected to a drain electrode 175, and a channel region 131 disposed between the source region 132 and the drain region 133.

A gate insulating film 140 is disposed on the semiconductor layer 130 and the buffer layer 120 where it is not covered with the semiconductor layer 130. The gate insulating film 140 may include an inorganic material, such as a silicon nitride or a silicon oxide, or may include an organic insulating material. Here, the silicon nitride may include, for example, SiNx or SiON, and the silicon oxide may include, for example, SiOₓ.

A gate electrode 124 may be disposed on the gate insulating film 140. The gate electrode 124 may overlap the channel region 131 of the semiconductor layer 130.

An interlayer insulating film 160 covering the gate electrode 124 and the exposed gate insulating film 140 is disposed thereon. The interlayer insulating film 160 may include an inorganic insulating material or an organic insulating material.

The source electrode 173 and the drain electrode 175 may be disposed on the interlayer insulating film 160. Each of the source electrode 173 and the drain electrode 175 is connected to the source region 132 and the drain region 133 of the semiconductor layer 130 through contact holes of the interlayer insulating film 160 and the gate insulating film 140.

A planarization insulating film 180 may be disposed on the source electrode 173, the drain electrode 175, and the interlayer insulating film 160 exposed therefrom. The planarization insulating film 180 may include an inorganic insulating material or an organic insulating material.

A pixel electrode 191, which is a first electrode, is disposed on the planarization insulating film 180. The pixel electrode 191 may be connected to the drain electrode 175 through a contact hole of the planarization insulating film 180.

A partition wall 360 may be disposed on the pixel electrode 191 and the planarization insulating film 180. The partition wall 360 may overlap at least a portion of the pixel electrode 191. The partition wall 360 has an opening 361 overlapping the pixel electrode 191. A light emitting layer 370 is disposed in the opening 361. A common electrode 270 is disposed on the light emitting layer 370 and the partition wall 360. An encapsulation substrate 400 is disposed on the common electrode 270. The encapsulation substrate 400 may have a structure in which an organic film and an inorganic film are alternately stacked, or may have a structure such as the substrate 110, but is not limited thereto. The pixel electrode 191, the light emitting layer 370, and the common electrode 270 form a light emitting diode.

In some embodiments, the pixel electrode may be an anode which is a hole injection electrode, and the common electrode may be a cathode which is an electron injection electrode. In contrast, the pixel electrode may be a cathode, and the common electrode may be an anode. When holes and electrons are injected into the light emitting layer from the pixel electrode and the common electrode, respectively, light is emitted when excitons in which the injected holes and electrons are combined enter a ground state from an excited state.

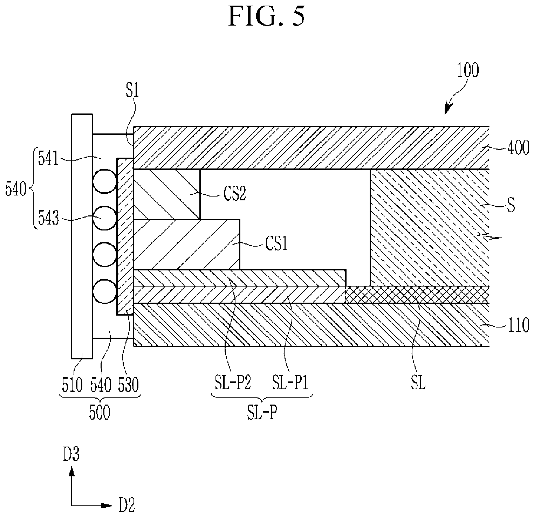

Hereinafter, the first side surface S1 to which the flexible film 500 and the display panel 100 are coupled according to an embodiment will be described with reference to FIG. 5. FIG. 5 illustrates a partial cross-sectional view of a display device in a first side surface according to an embodiment.

The display device according to the embodiment includes the flexible film 500 coupled to the first side surface S1 of the display panel 100.

The display panel 100 includes the substrate 110 described above, the encapsulation substrate 400 facing the substrate 110, an adhesive member S connecting the substrate 110 and the encapsulation substrate 400, and the signal pad SL-P connected to a signal line SL. According to the embodiment, spacers CS1 and CS2 may be disposed between the signal pad SL-P and the encapsulation substrate 400 to maintain a distance therebetween. The spacers CS1 and CS2 may include at least one layer, and may include two spacers CS1 and CS2, which are divided into two according to embodiments. However, the present invention is not limited to this embodiment.

The signal pad SL-P may be formed as a double layer according to an embodiment, but is not limited thereto. A first layer SL-P1 may include the same material as the above-described gate line, and a second layer SL-P2 may include the same material as the above-described data line. At least one of the first layer SL-P1 and the second layer SL-P2 may be omitted.

The adhesive member S may be disposed between the substrate 110 and the encapsulation substrate 400, and may be disposed along an edge of the substrate 110. The adhesive member S may include, for example, a sealing material.

The flexible film 500 according to the embodiment includes a base film 510 facing the first side surface S1 of the display panel 100, a driving electrode 530 electrically connected to the signal pad SL-P, and an anisotropic conductive layer 540 disposed between the base film 510 and the driving electrode 530. Although not shown in FIG. 5, the flexible film 500 may further include a driving chip electrically connected to the printed circuit board as shown in FIG. 1.

The base film 510 may be a flexible film, and may include any material.

The driving electrode 530 may be made of a metal material including copper (Cu), silver (Ag), gold (Au), or aluminum (Al). The driving electrode 530 may be formed through a laser patterning process after depositing a metal material according to an embodiment.

A number of driving electrodes 530 included in one flexible film 500 may be the same as that of signal pads SL-P overlapping one flexible film 500. The driving electrode 530 transmits the driving signal transmitted from the driving chip 550 shown in FIG. 1 to the signal pad SL-P. In addition, the driving electrode 530 may transmit a signal to the signal pad SL-P through the anisotropic conductive layer 540.

The anisotropic conductive layer 540 includes an adhesive layer 541 having adhesiveness and conductive particles 543 dispersed in the adhesive layer 541. The conductive particles 543 are positioned between a side surface of the driving electrode 530 and a side surface of the base film 510, and may electrically connect them.

As described above, by using the signal pad SL-P arranged on the first side surface S1 of the display panel 100 and the flexible film 500 connected to the signal pad SL-P, an area occupied by the peripheral area NA in the display panel 100 may be reduced compared to a method in which the signal pad and the flexible film overlap and are bonded to each other on one surface of the substrate 110.

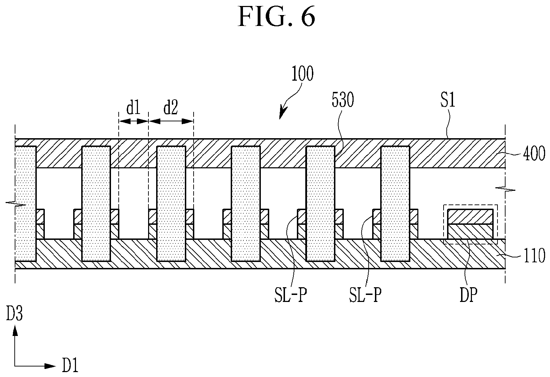

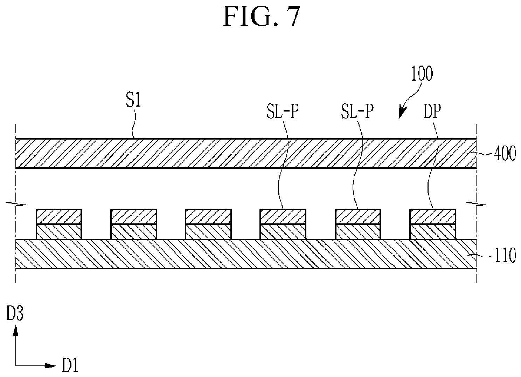

Hereinafter, the first side surface of the display panel according to the embodiment will be described in detail with reference to FIG. 6 to FIG. 9. FIG. 6 illustrates a cross-sectional view of some of constituent elements in a first side surface according to an embodiment, and FIG. 7, FIG. 8, and FIG. 9 illustrate cross-sectional views of a first side during a manufacturing process according to an embodiment. For convenience, a structure in which the driving electrode is disposed on the first side surface of the display panel is illustrated.

First, referring to FIG. 6, the plurality of signal pads SL-P and the dummy pad DP are arranged along the first side surface S1 of the display panel 100. The plurality of signal pads SL-P and the dummy pad DP are arranged along the first direction D1, that is the plurality of signal pads SL-P and the dummy pad DP may be positioned one behind another in the first direction D1.

In this case, the dummy pad DP may be disposed at the outermost side of the display panel 100 in the first direction D1. According to the embodiment, the structure in which the dummy pad DP is disposed at the rightmost side is illustrated, but the present invention is not limited thereto, and the dummy pad DP may be disposed at the leftmost side.

Distances d1 between the plurality of adjacent signal pads SL-P and the dummy pad DP may be substantially the same. In addition, distances d2 of each signal pad SL-P and the dummy pad DP may be substantially the same.

The driving electrode 530 according to the embodiment may overlap the signal pad SL-P. The dummy pad DP does not overlap and is spaced apart from the driving electrode 530.

A manufacturing method according to an embodiment will be briefly described with reference to FIG. 7 to FIG. 9.

First, as shown in FIG. 7, the dummy pad DP and the plurality of signal pads SL-P disposed between the substrate 110 and the encapsulation substrate 400 and arranged along the first direction D1 are prepared. The dummy pad DP and the plurality of signal pads SL-P are arranged along the first side surface S1. In this case, a width of the dummy pad DP and respective widths of the plurality of signal pads SL-P may be the same, and distances between the dummy pad DP and the plurality of signal pads SL-P adjacent to each other may be the same.

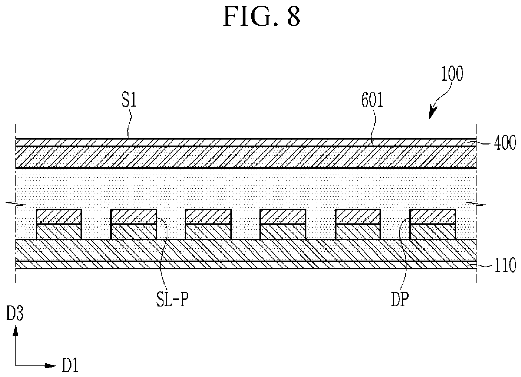

Next, as shown in FIG. 8, a metal material 601 is coated on the first side surface S1 of the display panel 100. The metal material 601 may be made of a metal material including copper (Cu), silver (Ag), gold (Au), or aluminum (Al).

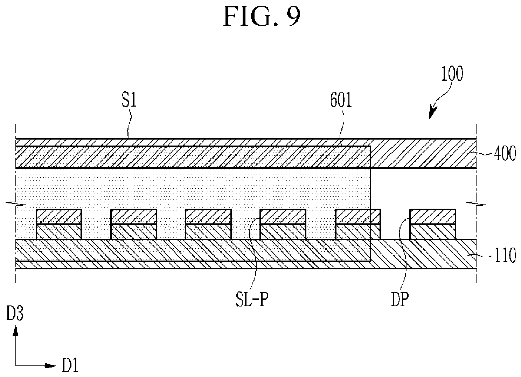

Then, as shown in FIG. 9, the metal material 601 is eliminated along the first direction D1 by using a laser process. When the dummy pad DP is exposed during the eliminating process, the metal material 601 may be patterned based on the dummy pad DP. Since the dummy pad DP and the plurality of signal pads SL-P have the same distance and width, when the dummy pad DP is exposed, the dummy pad DP is used as a reference point such as an alignment mark to pattern the metal material 601, thereby manufacturing the plurality of driving electrodes 530 as shown in FIG. 6.

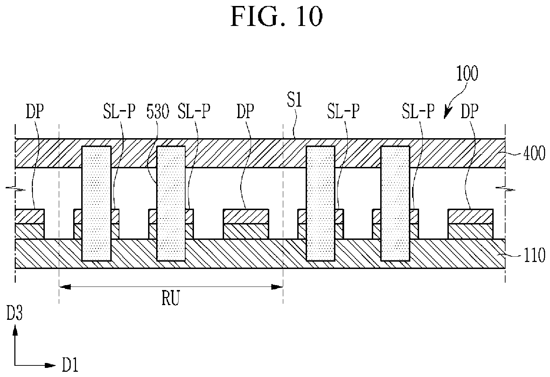

Hereinafter, the first side surface of the according to an embodiment will be described in more detail with reference to FIG. 10 through FIG. 13. FIG. 10, FIG. 11, FIG. 12, and FIG. 13 respectively illustrate a cross-sectional view of a first side of a display panel according to an embodiment. For convenience, the driving electrode, the signal pad, and the dummy pad disposed on the first side surface are illustrated. A description of the same constituent elements as those of the embodiment described above will be omitted below.

Now, referring to FIG. 10, the display panel 100 according to the embodiment may include at least two dummy pads DP. Each dummy pad DP may be disposed between the plurality of signal pads SL-P.

In FIG. 10, a region combined with one flexible film is divided by dotted lines for convenience. This is referred to as one repeated unit (RU). For example, one flexible film may be combined with three pads, and the number of pads to be combined is not limited.

One flexible film may be combined with or overlap one dummy pad DP and at least two or more signal pads SL-P. Each dummy pad DP may not overlap the driving electrode 530, and each signal pad SL-P may overlap the driving electrode 530.

Based on the repeated unit RU in which one soft film is attached, each repeated unit RU may include one dummy pad DP and at least one or more signal pads SL-P.

One repeated unit RU includes the dummy pad DP disposed at the outermost side in the repeated unit RU. That is, the dummy pad DP may be disposed at the outermost side in a region overlapping one flexible film. As described above, the dummy pad DP may function as one alignment mark while the laser eliminating process is performed along one direction. Since the driving electrode 530 is manufactured based on the dummy pad DP, respective signal pads SL-P and the driving electrode 530 may be stably overlapped and combined to increase reliability of the display device.

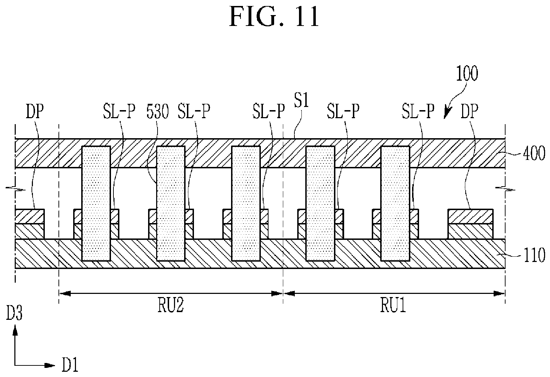

Next, referring to FIG. 11, at least one of the plurality of repeated units RU may include the dummy pad DP, and at least one repeated unit RU except the mentioned repeated unit may not include the dummy pad DP. In other words, at least one of the plurality of flexible films may overlap the dummy pad DP, and at least one of the plurality of flexible films except the mentioned flexible film may not overlap the dummy pad DP.

The repeated unit RU according to an embodiment may include a first repeated unit RU1 overlapping at least one dummy pad DP, and a second repeated unit RU2 overlapping the signal pad SL-P and not overlapping the dummy pad DP.

The first repeated unit RU1 may be disposed between the second repeated units RU2 according to a predetermined rule. For example, the first repeated unit RU1 may be disposed between adjacent second repeated units RU2, or the first repeated unit RU1 may be disposed between at least two second repeated units RU2. A position at which the first repeated unit RU1 is disposed may be selected according to the manufacturing process.

According to this embodiment, since the alignment between the driving electrode 530 and the signal pad SL-P may be continuously checked through the dummy pad DP disposed in a middle position of the plurality of pads, it is possible to provide a display device having improved reliability.

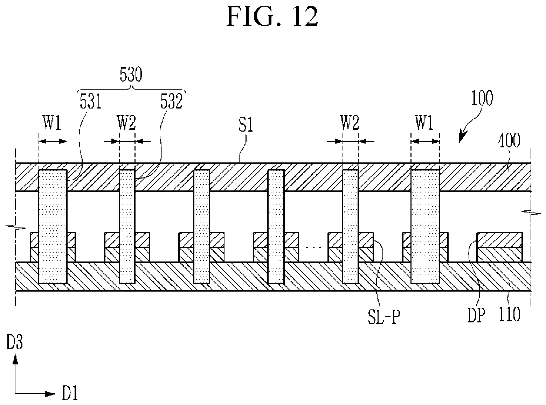

Next, referring to FIG. 12, the driving electrode 530 coupled to the first side surface S1 of the display panel 100 may include a first driving electrode 531 and a second driving electrode 532 having different widths.

A width W1 of the first driving electrode 531 may be greater than a width W2 of the second driving electrode 532. According to the embodiment, the first driving electrode 531 may be disposed at the outermost side of the plurality of driving electrodes 531 and 532.

The display panel 100 according to an embodiment may be curved. In this case, the coupling between the signal pads SL-P disposed at both ends of the display panel 100 and the driving electrode 530 may be vulnerable to mechanical stress. According to the embodiment, the first driving electrodes 531 disposed at both ends may have a larger coupling area with the signal pad SL-P through a relatively greater width, thereby enabling more stable coupling. The reliability of the display device according to the embodiment may be improved.

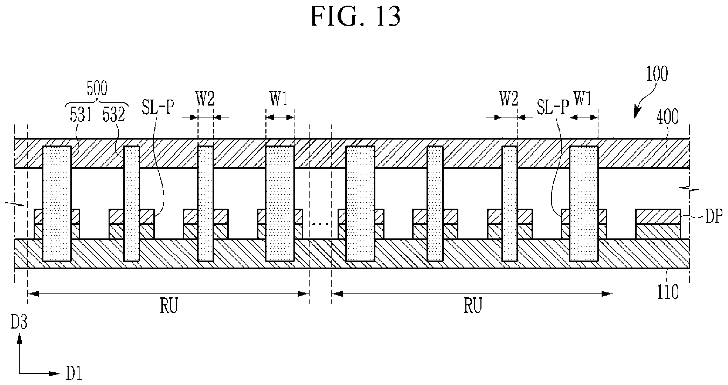

Next, referring to FIG. 13, one repeated unit RU combined with one flexible film is indicated by a dotted line for convenience. In the present specification, an embodiment in which one flexible film includes four driving electrodes 530 and is connected to four pads is illustrated, but the present invention is not limited thereto.

According to the embodiment, the driving electrode 530 coupled to the first side surface S1 of the display panel 100 may include the first driving electrode 531 and the second driving electrode 532 having different widths.

The width W1 of the first driving electrode 531 may be greater than the width W2 of the second driving electrode 532. According to the embodiment, one repeated unit RU may include at least one first driving electrode 531 and at least one second driving electrode 532. According to the embodiment, the first driving electrode 531 may be disposed at the outermost side based on one repeated unit RU, and at least one or more second driving electrode 532 may be disposed between two first driving electrodes 531 disposed at both ends thereof.

One repeated unit RU may overlap one flexible film, and as a width of the driving electrode 530 disposed at both ends overlapping the flexible film is wider, the coupling force between the flexible film and the display panel 100 may be improved. Therefore, the reliability of the display device may be improved.

Since the display device according to the embodiment includes the dummy pad disposed parallel to the signal pad, it is easy to pattern the driving electrode by using the dummy pad as an alignment mark. In addition, since the alignment between the driving electrode and the signal pad is accurately controlled by the dummy pad, a display device may provide improved reliability.

While this disclosure has been described in connection with what is presently considered to be practical embodiments, it is to be understood that the invention is not limited to the disclosed embodiments, but, on the contrary, is intended to cover various modifications and equivalent arrangements included within the scope of the appended claims.

## Claims

1. A display device (1), comprising:
a display panel (100) including a display area (DA); and
at least a flexible film (500) attached to a first side surface (S1) of the display panel (100),
wherein a normal vector of the first side surface (S1) is orientated in a second direction (D2), and
wherein the display panel (100) comprises:
a substrate (110);
at least a signal pad (SL-P) disposed on the substrate (110), wherein a portion of the at least one signal pad (SL-P) faces towards the same direction as the first side surface (S1); and
at least a dummy pad (DP) disposed adjacent to the signal pad (SL-P) in a first direction (D1) on the substrate (110),
wherein the first direction (D1) is orthogonal to the second direction (D2),
wherein the flexible film (500) comprises:
a base film (510) disposed to face the first side surface (S1), and
at least a driving electrode (530) disposed between the base film (510) and the signal pad (SL-P), and, as seen in the second direction (D2), overlapping the portion of the at least one signal pad (SL-P) and being electrically connected to the at least one signal pad (SL-P),
wherein
the display panel (100) further comprises an encapsulation substrate (400) spaced apart from the substrate (110) in a third direction (D3),
wherein the third direction (D3) is orthogonal to the first direction (D1) and second direction (D2),
wherein the at least one signal pad (SL-P) and the at least one dummy pad (DP) are disposed between the substrate (110) and the encapsulation substrate (400) on a surface of the substrate (110) whose normal vector is oriented in the third direction (D3), and
**characterised in that**
the at least one dummy pad (DP) is free of an overlap with an electrode.

2. The display device (1) of claim 1, wherein
the display panel (100) includes a flat surface directly connected to the first side surface (S1).

3. The display device (1) of claim 1 or 2, wherein
the display panel (100) comprises a signal line (SL) connected to the signal pad (SL-P).

4. The display device (1) of at least one of claims 1 to 3, wherein
side surfaces of the signal pad (SL-P) and the dummy pad (DP) are arranged along the first side surface (S 1) of the display panel (100).

5. The display device (1) of at least one of claims 1 to 4, wherein
the display area (DA) includes a gate line (121) and a data line (171) that are insulated from each other and cross each other, and
the signal pad (SL-P) and the dummy pad (DP) respectively include the same material as that of the gate line (121) and the data line (171).

6. The display device (1) of at least one of claims 1 to 5, wherein
the flexible film (500) further includes an anisotropic conductive layer (540) disposed between the base film (510) and the driving electrode (530), and
the anisotropic conductive layer (540) includes an adhesive layer (541) and conductive particles (543).

7. The display device (1) of at least one of claims 1 to 6, wherein
the display device (1) includes a plurality of flexible films (500), and
one of the plurality of flexible films (500) includes a plurality of driving electrodes (530).

8. The display device (1) of at least one of claims 1 to 7, wherein
the display panel (100) comprises a plurality of signal pads (SL-P),
the dummy pad (DP) is disposed between the plurality of signal pads (SL-P), and
one flexible film (500) overlaps at least one dummy pad (DP), and
wherein the dummy pad (DP) overlapping the one flexible film (500) overlaps the outermost side of the one flexible film (500).

9. The display device (1) of at least one of claims 1 to 8, wherein
the display device (1) includes a plurality of flexible films (500),
at least one of the plurality of flexible films (500) overlaps the dummy pad (DP), and
at least one of the plurality of flexible films (500) is spaced apart from the dummy pad (DP).

10. The display device (1) of at least one of claims 1 to 9, wherein
the flexible film (500) includes a plurality of driving electrodes (530), and
the plurality of driving electrodes (530) include a first driving electrode (531) and a second driving electrode (532) that have different widths (W1, W2).

11. The display device (1) of claim 10, wherein
the width (W1) of the first driving electrode (531) is greater than the width (W2) of the second driving electrode (532), and
the first driving electrode (531) is disposed at the outermost side of the plurality of driving electrodes (530).

12. The display device (1) of claim 10 or 11, wherein
the width (W1) of the first driving electrode (531) is greater than that the width (W2) of the second driving electrode (532), and
at least one of the plurality of flexible films (500) overlaps at least two of the first driving electrodes (531).

13. The display device (1) of at least one of claims 1 to 12, wherein
the display panel (100) includes a peripheral area (NA) disposed outside the display area (DA); and
wherein the display panel (100) comprises
a plurality of signal pads (SL-P) arranged along the first side surface (S1); and
the dummy pad (DP) is disposed parallel to the plurality of signal pads (SL-P), and
wherein the driving electrode (530) is spaced apart from the dummy pad (DP).

14. The display device (1) of at least one of claims 1 to 13, wherein
the display device (1) includes a plurality of flexible films (500),
one of the plurality of flexible film (500) overlaps the dummy pad (DP), and
the dummy pad (DP) overlapping the one flexible film (500) is disposed at the outermost side of the one flexible film (500).

15. A method for manufacturing a display device (1) of at least one of the claims 1 to 14,
the method comprising the following steps:
- preparing of the dummy pad (DP) and a plurality of signal pads (SL-P) disposed on the substrate (110) on the surface of the substrate (110) whose normal vector is oriented in the third direction (D3), wherein the dummy pad (DP) and the plurality of signal pads (SL-P) are arranged along the first direction (D1);
- coating a metal material (601) on the first side surface (S1) of the display panel (100), electrically connecting at least the plurality of signal pads (SL-P) to the metal material (601);
**characterised in that** the method further comprises the steps of
- eliminating the metal material (601) along the first direction (D1) by using a laser process so as to expose the dummy pad (DP); and
- patterning of the remaining metal material (601) by using the dummy pad (DP) as a reference point to manufacture a plurality of driving electrodes (530).

## Patentansprüche

1. Anzeigevorrichtung (1), umfassend:
ein Anzeigefeld (100), das einen Anzeigebereich (DA) beinhaltet; und
mindestens eine flexible Folie (500), die an einer ersten Seitenfläche (S1) des Anzeigefelds (100) angebracht ist,
wobei ein Normalenvektor der ersten Seitenfläche (S1) in einer zweiten Richtung (D2) ausgerichtet ist, und
wobei das Anzeigefeld (100) Folgendes umfasst:
ein Substrat (110);
mindestens ein Signal-Pad (SL-P), das auf dem Substrat (110) angeordnet ist, wobei ein Abschnitt des mindestens einen Signal-Pads (SL-P) in die gleiche Richtung wie die erste Seitenfläche (S1) zeigt; und
mindestens ein Dummy-Pad (DP), das benachbart zu dem Signal-Pad (SL-P) in einer ersten Richtung (D1) auf dem Substrat (110) angeordnet ist,
wobei die erste Richtung (D1) orthogonal zu der zweiten Richtung (D2) ist,
wobei die flexible Folie (500) Folgendes umfasst:
eine Basisfolie (510), die so angeordnet ist, dass sie der ersten Seitenfläche (S1) zugewandt ist, und
mindestens eine Antriebselektrode (530), die zwischen der Basisfolie (510) und dem Signal-Pad (SL-P) angeordnet ist, und, wie in der zweiten Richtung (D2) betrachtet, den Abschnitt des mindestens einen Signal-Pads (SL-P) überlappt und mit dem mindestens einen Signal-Pad (SL-P) elektrisch verbunden ist,
wobei das Anzeigefeld (100) ferner ein Einkapselungssubstrat (400) umfasst, das von dem Substrat (110) in einer dritten Richtung (D3) beabstandet ist,
wobei die dritte Richtung (D3) orthogonal zu der ersten Richtung (D1) und der zweiten Richtung (D2) ist,
wobei das mindestens eine Signal-Pad (SL-P) und das mindestens eine Dummy-Pad (DP) zwischen dem Substrat (110) und dem Einkapselungssubstrat (400) auf einer Oberfläche des Substrats (110) angeordnet sind, dessen Normalenvektor in der dritten Richtung (D3) ausgerichtet ist, und
**dadurch gekennzeichnet, dass** das mindestens eine Dummy-Pad (DP) frei von einer Überlappung mit einer Elektrode ist.

2. Anzeigevorrichtung (1) nach Anspruch 1, wobei
das Anzeigefeld (100) eine flache Fläche beinhaltet, die direkt mit der ersten Seitenfläche (S1) verbunden ist.

3. Anzeigevorrichtung (1) nach Anspruch 1 oder 2, wobei
das Anzeigefeld (100) eine Signalleitung (SL) umfasst, die mit dem Signal-Pad (SL-P) verbunden ist.

4. Anzeigevorrichtung (1) nach mindestens einem der Ansprüche 1 bis 3, wobei
Seitenflächen des Signal-Pads (SL-P) und des Dummy-Pads (DP) entlang der ersten Seitenfläche (S1) des Anzeigefelds (100) angeordnet sind.

5. Anzeigevorrichtung (1) nach mindestens einem der Ansprüche 1 bis 4, wobei
der Anzeigebereich (DA) eine Gateleitung (121) und eine Datenleitung (171) beinhaltet, die voneinander isoliert sind und einander kreuzen, und das Signal-Pad (SL-P) und das Dummy-Pad (DP) jeweils das gleiche Material wie das der Gateleitung (121) und der Datenleitung (171) beinhalten.

6. Anzeigevorrichtung (1) nach mindestens einem der Ansprüche 1 bis 5, wobei
die flexible Folie (500) ferner eine anisotrope leitfähige Schicht (540) beinhaltet, die zwischen der Basisfolie (510) und der Antriebselektrode (530) angeordnet ist, und
die anisotrope leitfähige Schicht (540) eine Kleberschicht (541) und leitfähige Partikel (543) beinhaltet.

7. Anzeigevorrichtung (1) nach mindestens einem der Ansprüche 1 bis 6, wobei
die Anzeigevorrichtung (1) eine Vielzahl von flexiblen Folien (500) beinhaltet, und
eine der Vielzahl von flexiblen Folien (500) eine Vielzahl von Antriebselektroden (530) beinhaltet.

8. Anzeigevorrichtung (1) nach mindestens einem der Ansprüche 1 bis 7, wobei
das Anzeigefeld (100) eine Vielzahl von Signal-Pads (SL-P) umfasst,
das Dummy-Pad (DP) zwischen der Vielzahl von Signal-Pads (SL-P) angeordnet ist, und
eine flexible Folie (500) mindestens ein Dummy-Pad (DP) überlappt, und wobei das Dummy-Pad (DP), das die eine flexible Folie (500) überlappt, die äußerste Seite der einen flexiblen Folie (500) überlappt.

9. Anzeigevorrichtung (1) nach mindestens einem der Ansprüche 1 bis 8, wobei
die Anzeigevorrichtung (1) eine Vielzahl von flexiblen Folien (500) beinhaltet,
mindestens eine der Vielzahl von flexiblen Folien (500) das Dummy-Pad (DP) überlappt, und
mindestens eine der Vielzahl von flexiblen Folien (500) von dem Dummy-Pad (DP) beabstandet ist.

10. Anzeigevorrichtung (1) nach mindestens einem der Ansprüche 1 bis 9, wobei
die flexible Folie (500) eine Vielzahl von Antriebselektroden (530) beinhaltet, und
die Vielzahl von Antriebselektroden (530) eine erste Antriebselektrode (531) und eine zweite Antriebselektrode (532) beinhaltet, die unterschiedliche Breiten (W1, W2) aufweisen.

11. Anzeigevorrichtung (1) nach Anspruch 10, wobei
die Breite (W1) der ersten Antriebselektrode (531) größer als die Breite (W2) der zweiten Antriebselektrode (532) ist, und
die erste Antriebselektrode (531) an der äußersten Seite der Vielzahl von Antriebselektroden (530) angeordnet ist.

12. Anzeigevorrichtung (1) nach Anspruch 10 oder 11, wobei
die Breite (W1) der ersten Antriebselektrode (531) größer als die Breite (W2) der zweiten Antriebselektrode (532) ist, und
mindestens eine der Vielzahl flexibler Folien (500) mindestens zwei der ersten Antriebselektroden (531) überlappt.

13. Anzeigevorrichtung (1) nach mindestens einem der Ansprüche 1 bis 12, wobei
das Anzeigefeld (100) einen Randbereich (NA) beinhaltet, der außerhalb des Anzeigebereichs (DA) angeordnet ist; und
wobei das Anzeigefeld (100) Folgendes umfasst:
eine Vielzahl von Signal-Pads (SL-P), die entlang der ersten Seitenfläche (S1) angeordnet sind; und
das Dummy-Pad (DP) parallel zu der Vielzahl von Signal-Pads (SL-P) angeordnet ist, und
wobei die Antriebselektrode (530) von dem Dummy-Pad (DP) beabstandet ist.

14. Anzeigevorrichtung (1) nach mindestens einem der Ansprüche 1 bis 13, wobei
die Anzeigevorrichtung (1) eine Vielzahl von flexiblen Folien (500) beinhaltet,
eine der Vielzahl von flexiblen Folien (500) das Dummy-Pad (DP) überlappt, und
das Dummy-Pad (DP), das die eine flexible Folie (500) überlappt, an der äußersten Seite der einen flexiblen Folie (500) angeordnet ist.

15. Verfahren zum Herstellen einer Anzeigevorrichtung (1) nach mindestens einem der Ansprüche 1 bis 14, wobei das Verfahren die folgenden Schritte umfasst:
- Vorbereiten des Dummy-Pads (DP) und einer Vielzahl von Signal-Pads (SL-P), die auf dem Substrat (110) auf der Oberfläche des Substrats (110) angeordnet sind, deren Normalenvektor in der dritten Richtung (D3) ausgerichtet ist, wobei das Dummy-Pad (DP) und die Vielzahl von Signal-Pads (SL-P) entlang der ersten Richtung (D1) angeordnet sind;
- Beschichten der ersten Seitenfläche (S1) des Anzeigefelds (100) mit einem Metallmaterial (601), das mindestens die Vielzahl von Signal-Pads (SL-P) mit dem Metallmaterial (601) elektrisch verbindet;
**dadurch gekennzeichnet, dass** das Verfahren ferner die folgenden Schritte umfasst:
- Beseitigen des Metallmaterials (601) entlang der ersten Richtung (D1) unter Verwendung eines Laserprozesses, um das Dummy-Pad (DP) freizulegen; und
- Strukturieren des verbleibenden Metallmaterials (601) unter Verwendung des Dummy-Pads (DP) als ein Referenzpunkt, um eine Vielzahl von Antriebselektroden (530) herzustellen.

## Revendications

1. Dispositif d'affichage (1), comprenant :
un panneau d'affichage (100) incluant une zone d'affichage (DA) ; et
au moins un film flexible (500) attaché à une première surface latérale (S1) du panneau d'affichage (100),
dans lequel un vecteur normal de la première surface latérale (S1) est orienté dans une deuxième direction (D2), et
dans lequel le panneau d'affichage (100) comprend :
un substrat (110) ;
au moins un plot de signal (SL-P) disposé sur le substrat (110), dans lequel une portion de l'au moins un plot de signal (SL-P) fait face vers la même direction que la première surface latérale (S1) ; et
au moins un plot fictif (DP) disposé adjacent au plot de signal (SL-P) dans une première direction (D1) sur le substrat (110),
dans lequel la première direction (D1) est orthogonale à la deuxième direction (D2),
dans lequel le film flexible (500) comprend :
un film de base (510) disposé pour faire face à la première surface latérale (S1), et
au moins une électrode de pilotage (530) disposée entre le film de base (510) et le plot de signal (SL-P), et, comme vu dans la deuxième direction (D2), chevauchant la portion de l'au moins un plot de signal (SL-P) et étant connectée électriquement à l'au moins un plot de signal (SL-P), dans lequel
le panneau d'affichage (100) comprend en outre un substrat d'encapsulation (400) espacé du substrat (110) dans une troisième direction (D3),
dans lequel la troisième direction (D3) est orthogonale à la première direction (D1) et à la deuxième direction (D2),
dans lequel l'au moins un plot de signal (SL-P) et l'au moins un plot fictif (DP) sont disposés entre le substrat (110) et le substrat d'encapsulation (400) sur une surface du substrat (110) dont le vecteur normal est orienté dans la troisième direction (D3), et
**caractérisé en ce que**
l'au moins un plot fictif (DP) est exempt de chevauchement avec une électrode.

2. Dispositif d'affichage (1) selon la revendication 1, dans lequel
le panneau d'affichage (100) inclut une surface plate directement connectée à la première surface latérale (S1).

3. Dispositif d'affichage (1) selon la revendication 1 ou 2, dans lequel
le panneau d'affichage (100) comprend une ligne de signal (SL) connectée au plot de signal (SL-P).

4. Dispositif d'affichage (1) selon au moins l'une des revendications 1 à 3, dans lequel
des surfaces latérales du plot de signal (SL-P) et du plot fictif (DP) sont agencées le long de la première surface latérale (S1) du panneau d'affichage (100).

5. Dispositif d'affichage (1) selon au moins l'une des revendications 1 à 4, dans lequel
la zone d'affichage (DA) inclut une ligne de grille (121) et une ligne de données (171) qui sont isolées l'une de l'autre et se croisent l'une l'autre, et
le plot de signal (SL-P) et le plot fictif (DP) incluent respectivement le même matériau que celui de la ligne de grille (121) et de la ligne de données (171).

6. Dispositif d'affichage (1) selon au moins l'une des revendications 1 à 5, dans lequel
le film flexible (500) inclut en outre une couche conductrice anisotrope (540) disposée entre le film de base (510) et l'électrode de pilotage (530), et
la couche conductrice anisotrope (540) inclut une couche adhésive (541) et des particules conductrices (543).

7. Dispositif d'affichage (1) selon au moins l'une des revendications 1 à 6, le dispositif d'affichage (1) incluant une pluralité de films flexibles (500), et un de la pluralité de films flexibles (500) inclut une pluralité d'électrodes de pilotage (530).

8. Dispositif d'affichage (1) selon au moins l'une des revendications 1 à 7, dans lequel
le panneau d'affichage (100) comprend une pluralité de plots de signal (SL-P),
le plot fictif (DP) est disposé entre la pluralité de plots de signal (SL-P), et un film flexible (500) chevauche au moins un plot fictif (DP), et
dans lequel le plot fictif (DP) chevauchant ledit un film flexible (500) chevauche le côté le plus externe dudit un film flexible (500).

9. Dispositif d'affichage (1) selon au moins l'une des revendications 1 à 8, le dispositif d'affichage (1) incluant une pluralité de films flexibles (500), au moins un de la pluralité de films flexibles (500) chevauche le plot fictif (DP), et
au moins un de la pluralité de films flexibles (500) est espacé du plot fictif (DP).

10. Dispositif d'affichage (1) selon au moins l'une des revendications 1 à 9, dans lequel
le film flexible (500) comprend une pluralité d'électrodes de pilotage (530), et
la pluralité d'électrodes de pilotage (530) inclut une première électrode de pilotage (531) et une deuxième électrode de pilotage (532) qui ont des largeurs différentes (W1, W2).

11. Dispositif d'affichage (1) selon la revendication 10, dans lequel
la largeur (W1) de la première électrode de pilotage (531) est supérieure à la largeur (W2) de la deuxième électrode de pilotage (532), et
la première électrode de pilotage (531) est disposée du côté le plus externe de la pluralité d'électrodes de pilotage (530).

12. Dispositif d'affichage (1) selon la revendication 10 ou 11, dans lequel
la largeur (W1) de la première électrode de pilotage (531) est supérieure à la largeur (W2) de la deuxième électrode de pilotage (532), et
au moins un de la pluralité de films flexibles (500) chevauche au moins deux des premières électrodes de pilotage (531).

13. Dispositif d'affichage (1) selon au moins l'une des revendications 1 à 12, dans lequel
le panneau d'affichage (100) inclut une zone périphérique (NA) disposée à l'extérieur de la zone d'affichage (DA) ; et
dans lequel le panneau d'affichage (100) comprend
une pluralité de plots de signal (SL-P) agencés le long de la première surface latérale (S1) ; et
le plot fictif (DP) est disposé parallèlement à la pluralité de plots de signal (SL-P), et
dans lequel l'électrode de pilotage (530) est espacée du plot fictif (DP).

14. Dispositif d'affichage (1) selon au moins l'une des revendications 1 à 13, le dispositif d'affichage (1) incluant une pluralité de films flexibles (500), un de la pluralité de films flexibles (500) chevauche le plot fictif (DP), et
le plot fictif (DP) chevauchant ledit un film flexible (500) est disposé du côté le plus externe dudit un film flexible (500).

15. Procédé de fabrication d'un dispositif d'affichage (1) d'au moins l'une des revendications 1 à 14,
le procédé comprenant les étapes suivantes :
- la préparation du plot fictif (DP) et d'une pluralité de plots de signal (SL-P) disposés sur le substrat (110) sur la surface du substrat (110) dont le vecteur normal est orienté dans la troisième direction (D3), dans lequel le plot fictif (DP) et la pluralité de plots de signal (SL-P) sont agencés le long de la première direction (D1) ;
- le revêtement d'un matériau métallique (601) sur la première surface latérale (S1) du panneau d'affichage (100), en connectant électriquement au moins la pluralité de plots de signal (SL-P) au matériau métallique (601) ;
**caractérisé en ce que** le procédé comprend en outre les étapes de
- élimination du matériau métallique (601) le long de la première direction (D1) à l'aide d'un processus laser de façon à exposer le plot fictif (DP) ; et
la formation en motif du matériau métallique (601) restant à l'aide du plot fictif (DP) comme point de référence pour fabriquer une pluralité d'électrodes de pilotage (530).
